# EUROPÄISCHE PATENTSCHRIFT

(11) **EP 3 915 153 B1**
(45) Veröffentlichungstag und Bekanntmachung des Hinweises auf die Patenterteilung: **26.06.2024**
(21) Anmeldenummer: 20703943.9
(22) Anmeldetag: 23.01.2020
(51) Int. Cl.: H10N 30/20, H10N 30/88, F03G 7/06

(54) **AKTOR MIT RÜCKSTELLFEDERN**
ACTUATOR HAVING RESTORING SPRINGS
ACTIONNEUR POURVU DE RESSORTS DE RAPPEL

(30) Priorität: 24.01.2019 DE 102019101717
(43) Veröffentlichungstag der Anmeldung: 01.12.2021
(73) Patentinhaber: Universität des Saarlandes, 66123 Saarbrücken (DE)
(72) Erfinder: HAU, Steffen, 66424 Homburg (DE); LINNEBACH, Philipp, 66557 Illingen (DE); SEELECKE, Stefan, 66119 Saarbrücken (DE)
(74) Vertreter: Zeiner, Johannes Michael
(86) Internationale Anmeldenummer: PCT/EP2020/051557
(87) Internationale Veröffentlichungsnummer: WO 2020/152237

(56) Entgegenhaltungen:
- EP-B1- 2 097 937
- DE-A1-102012 211 696
- DE-B4-112008 003 596
- HAU S ET AL: "Silicone based dielectric elastomer strip actuators coupled with nonlinear biasing elements for large actuation strains", SMART MATERIALS AND STRUCTURES, Bd. 27, 074003, 5. Juni 2018 (2018-06-05), XP020328329, ISSN: 0964-1726, DOI: 10.1088/1361-665X/AAB7D8
- HAU S ET AL: "A novel design concept to boost the force output of dielectric elastomer membrane actuators", ELECTROACTIVE POLYMER ACTUATORS AND DEVICES (EAPAD) XXI, 4-7 MARCH 2019, DENVER, CO, USA; PROCEEDINGS OF SPIE, Bd. 10966, 109660N, 2019, XP060121698, ISSN: 0277-786X, DOI: 10.1117/12.2514210 ISBN: 978-1-5106-3377-3

## Beschreibung

Die Erfindung betrifft einen Aktor, der aus einer Grundstellung heraus in eine Arbeitsstellung bewegbar ist und mindestens ein in seinen Abmessungen durch ein elektrisches Signal veränderbares Aktorelement aufweist, wobei zur Bewegung in die Arbeitsstellung mindestens zwei auf das Aktorelement einwirkende Rückstellmittel vorgesehen sind, und wobei das mindestens eine Aktorelement zwischen den mindestens zwei auf das Aktorelement einwirkenden Rückstellmitteln schwimmend gelagert ist.

Ein Aktor mit einer vorgespannten Rückstellanordnung, die eine lineare Feder kombiniert mit einer nichtlinearen Feder umfasst, ist aus Hau S. et al. "Silicone besed dielectric elastomer strip actuators coupled with nonlinear biasing elements for large actuation strains", Smart Materials and Structures, Bd. 27, 074003, 5. Juni 2018 (XP020328329) bekannt. Aus EP 2 097 937 B1 ist eine ähnliche Anordnung mit einem elektroaktiven Polymer-Aktorelement bekannt. DE 10 2012 211 696 A1 beschreibt einen Aktor mit einem Aktorelement, das aus einer Formgedächtnislegierung gebildet ist, und zwei magnetischen nichtlinearen Vorspannelementen. Ein schwimmend gelagerter Aktor mit linearen Federn ist aus DE 11 2008 003 596 B4 bekannt.

Aus dem Stand der Technik ist ferner ein Aktor bekannt, der ein als folienförmiges dielektrisches Elastomer ausgebildetes Aktorelement (DE-Aktor) aufweist, das mit einem einzigen Rückstellmittel, beispielsweise einer Schnappfeder, in Reihe geschaltet ist. Beim Anlegen eines elektrischen Signals, das eine Hochspannung sein kann, erfolgt durch eine Verlängerung des Aktorelements eine Bewegung aus der Grundstellung in eine Endstellung, bei der die Schnappfeder aus einer ersten in eine zweite Gleichgewichtsstellung umschnappen und ein Betätigungselement betätigen kann. Wird das elektrische Signal entfernt, erfolgt eine Rückbewegung in die Grundstellung, bei der das Aktorelement in seine ursprüngliche, verkürzte Stellung zurückkehrt und die Schnappfeder in ihre erste Gleichgewichtsstellung mitnimmt. Durch geeignete Signalwahl sind Arbeitsstellungen zwischen der Grundstellung und der Endstellung ansteuerbar.

Ferner ist aus dem Stand der Technik ein Aktorelement bekannt, das aus einer Formgedächtnislegierung (Shape Memory Alloy, SMA; SMA-Aktor) gebildet ist. Formgedächtnislegierungen sind mechanisch verformbar und können durch Erwärmung, beispielsweise durch Beaufschlagung mit einem elektrischen Strom, in einen unverformten Ausgangszustand zurückkehren. Ein SMA-Aktorelement ist üblicherweise mit einem einzigen Rückstellmittel, das insbesondere eine Schraubenfeder sein kann, in Reihe geschaltet. Sowohl bei dem bekannten DE-Aktor als auch bei dem bekannten SMA-Aktor ist ein Ende des Aktorelements fest mit einem Aktorgehäuse oder mit einem Aktorrahmen verbunden. Dadurch wirkt das Aktorgehäuse oder der Aktorrahmen bei einer Bewegung aus der Grundstellung heraus in eine der möglichen Arbeitsstellungen und zurück als festes Widerlager.

Während ein DE-Aktor große Hübe bei moderater Krafterzeugung ermöglicht, ermöglicht ein SMA-Aktor kleine Hübe bei Erzeugung einer großen Kraft.

Der vorliegenden Erfindung liegt die Aufgabe zugrunde, einen Aktor zu schaffen, der die Nachteile bekannter Aktoren überwindet. Insbesondere kann mit einem DE-Aktor eine große Kraft erzeugt werden und mit einem SMA-Aktor ein großer Hub. Denkbar sind ferner auf einzelne besondere Anwendungsfälle zugeschnittene Kraft/Hub-Kombinationen.

Erfindungsgemäß wird die Aufgabe gemäß Anspruch 1 dadurch gelöst, dass ein erstes Rückstellmittel mindestens eine nichtlineare Feder umfasst.

Durch die mindestens zwei Rückstellmittel kann eine Gesamtrückstellmittelkennlinie, die sich aus Anteilen der einzelnen, vorzugsweise vorgespannten Rückstellmittel sowie einem Anteil einer veränderbaren Steifigkeit des Aktorelements zusammensetzt, vorteilhaft maßgeschneidert werden. Insbesondere von den Rückstellmitteln kann Energie gespeichert werden, die zur Bewegung aus der Grundstellung heraus in die Arbeitsstellung oder eine Endstellung zur Verfügung steht und die zur Erzeugung eines großen Hubes und/oder einer großen Kraft nutzbar ist. Ferner kann über die gesamte Bewegung aus der Grundstellung in die Arbeitsstellung oder in die Endstellung ein gleichmäßiger Hubweg oder eine gleichmäßige Krafterzeugung sichergestellt werden. Dies ist insbesondere für Anwendungen in der Robotik vorteilhaft.

Ein festes Widerlager, das unmittelbar mit dem Aktorelement verbunden ist, ist nicht vorgesehen. Vorteilhaft treten keine Lagerkräfte auf. Die von den insbesondere vorgespannten Rückstellmitteln gespeicherte Energie steht zur Bewegung aus einer Grundin eine Arbeitsstellung des Aktors zur Verfügung.

In einer Ausgestaltung der Erfindung sind ein erstes und ein zweites Rückstellmittel gleich oder voneinander verschieden. Die Rückstellmittel können auf gegenüberliegenden Seiten des Aktorelementes angeordnet sein und dem Aktorelement eine freie ("schwimmende") Bewegung insbesondere in oder entgegen einer Wirkrichtung der Rückstellmittel ermöglichen. Sind die Rückstellmittel gleich ausgebildet, wird eine Herstellung vereinfacht. Sind die Rückstellmittel voneinander verschieden ausgebildet, können ein erforderlicher Hubweg oder eine erforderliche zu erzeugende Kraft eingestellt werden. Jedes der Rückstellmittel kann eine Feder aufweisen, beispielsweise eine Schnappfeder, eine Schraubenfeder und/oder eine Schraubenzugfeder.

Eine Schnappfeder ist jede Feder mit einer nichtlinearen Kennlinie, die durch eine Kraft aus einer ersten Gleichgewichtsstellung in eine zweite Gleichgewichtsstellung, die von der ersten verschieden ist, bewegbar ist.

Ferner kann jedes der Rückstellmittel eine lineare oder nichtlineare Rückstellmittelkennlinie aufweisen.

In einer weiteren Ausgestaltung der Erfindung umfasst das erste Rückstellmittel eine Schnappfeder, und/oder ein zweites Rückstellmittel mindestens eine lineare Feder, insbesondere eine Schraubenfeder. Eine nichtlineare Feder weist eine nichtlineare Federkennlinie auf, eine lineare Feder eine lineare Federkennlinie.

Die Verwendung einer Schnappfeder und einer Schraubenfeder hat sich als besonders vorteilhaft erwiesen, um bauartunabhängig eine große Kraft bei gleichzeitig großem Hub zu bewirken. Durch ein Umschnappen der Schnappfeder aus einer ersten in eine zweite Gleichgewichtslage kann ein großer Hub bewirkt werden, der von einem Schnappweg abhängt, während die lineare Feder die Erzeugung einer großen Kraft begünstigt.

Denkbar ist außerdem, dass ein erstes Rückstellmittel einen aus einem magnetischen Material gebildeten Körper aufweist, der in veränderbarem Abstand zu einer aus einem Metall gebildeten Platte oder einem weiteren, aus einem magnetischen Material gebildeten Körper angeordnet ist. Der magnetische Körper und die Platte oder der weitere magnetische Körper weisen an einander zugewandten Flächen eine entgegengesetzte oder gleiche Polung auf. Im Fall einer gleichen Polung nimmt eine magnetische Abstoßungskraft mit abnehmendem Abstand zu, im Fall einer entgegengesetzten Polung nimmt eine magnetische Anziehungskraft mit abnehmendem Abstand zu.

Durch diese Anordnung ist die Ausbildung einer nichtlinearen Anziehungskraftkennlinie möglich. Der technische Effekt ist analog zu demjenigen, der mit einer nichtlinearen Feder, insbesondere einer Schnappfeder, erreichbar ist.

Zweckmäßigerweise weist eines der Rückstellmittel mindestens eine nichtlineare Feder auf, die vorzugsweise als Schnappfeder ausgebildet ist, deren Endabschnitte schräg, waagerecht oder senkrecht zu einem Aktorrahmenseitenteil eines Aktorrahmens angeordnet sind. Üblicherweise ist das mindestens eine Aktorelement von einem Aktorgehäuse oder einem Aktorrahmen umgeben. Werden Endabschnitte einer nichtlinearen Feder senkrecht zu dem Aktorrahmenseitenteil in dieses eingebracht, kann eine andere aktorspezifische Federkennlinie eingestellt werden als wenn die Endabschnitte schräg zu dem Aktorrahmenseitenteil in dieses eingebracht sind. Sind die Endabschnitte schräg in ein Aktorrahmenseitenteil hineingeführt und mit diesem verbunden, kann die vorzugsweise als Schnappfeder ausgebildete nichtlineare Feder ausschließlich in eine Arbeitsrichtung, das heißt aus der Grundstellung des Aktors in eine Endstellung umschnappen. Ein Umschnappen in eine Richtung, die der Arbeitsrichtung entgegengesetzt ist und die über eine Grundstellung hinausginge, wird vorteilhaft vermieden.

In einer Ausgestaltung der Erfindung ist das mindestens eine Aktorelement planar, zylindrisch oder kegelstumpfförmig ausgebildet. Ein planares Aktorelement ist vorzugsweise aus einem dielektrischen Polymer, insbesondere einem dielektrischen Elastomer, gebildet. Ein zylindrisch ausgebildetes Aktorelement ist aus einem eine Formgedächtnislegierung aufweisenden Draht gebildet.

Denkbar ist außerdem, dass das mindestens eine Aktorelement aus einer zu einem Zylinder zusammengerollten dielektrischen Elastomerfolie gebildet ist. Der Zylinder ist dazu eingerichtet, beim Anlegen eines elektrischen Signals, beispielsweise einer Hochspannung, seine Länge zu vergrößern und seinen Radius zu verringern.

In einer weiteren Ausgestaltung der Erfindung ist eine Länge des mindestens einen Aktorelements durch ein elektrisches Signal veränderbar ist, wobei eine Längenänderung vorzugsweise in einer Aktorelementebene oder entlang einer Symmetrieachse in einer Längsrichtung erfolgt. Denkbar ist auch, dass die Längenänderung parallel zu einem insbesondere geraden Aktorrahmenseitenteil eines das wenigstens eine Aktorelement umgebenden Aktorrahmens oder Aktorgehäuses erfolgt. Eine Änderung der Länge erfolgt beim Anlegen einer Spannung in oder entgegen einer Wirkrichtung von Kräften der Rückstellmittel an Aktorelementenden, an denen Rückstellmittel angreifen. Vorteilhaft kann eine besonders große Kraft und/oder ein besonders großer Hub bewirkt werden.

Ist das mindestens eine Aktorelement aus einer zu einem Zylinder zusammengerollten dielektrischen Elastomerfolie gebildet, erfolgt eine Längenänderung entlang der Zylinderachse und/oder in radialer Richtung.

Zweckmäßigerweise ist das mindestens eine Aktorelement in eine Richtung auslenkbar, die parallel oder koaxial zu einer Wirkrichtung einer Rückstellkraft mindestens eines der auf das Aktorelement einwirkenden Rückstellmittel ist. Rückstellkräfte können unmittelbar eine Auslenkung bewirken. Ein Verlust, beispielsweise durch Querkräfte, die keinen Beitrag zur Auslenkung beitragen, wird vorteilhaft verhindert.

In einer Ausgestaltung der Erfindung ist wenigstens eines der beiden Rückstellmittel innerhalb des Aktorrahmens oder des Aktorgehäuses angeordnet. Beispielsweise kann das Aktorgehäuse vor Verschmutzung schützen. Eine höhere Lebensdauer ist möglich.

In einer Ausgestaltung der Erfindung sind ein erster Endabschnitt des Aktorelements und ein zweiter, dem ersten Abschnitt vorzugsweise gegenüberliegender Endabschnitt mit Halteelementen, insbesondere Klemmschienen, versehen. Vorteilhaft können Enden des Aktorelements, an denen Kräfte der Rückstellmittel angreifen, besonders gut gehalten werden. Außerdem können mehrere parallel zueinander angeordnete Aktorelemente, insbesondere planare, in einer stabilen Lage zueinander fixiert werden.

Zweckmäßigerweise ist ein Betätigungsmittel vorgesehen, das gleichzeitig zur Führung einer Bewegung aus der Grundstellung heraus in die Arbeitsstellung eingerichtet ist. Dazu kann das Führungsmittel zylindrisch ausgebildet sein und durch eine Öffnung in dem Aktorrahmen oder dem Aktorgehäuse herausgeführt sein. Vorteilhaft kann eine gerichtete Kraft aufgebracht werden. Insbesondere kann eine Längsachse des Betätigungsmittels koaxial zu einer Wirkrichtung der Rückstellmittel sein. Außerdem kann das Betätigungsmittel bis in eine Endstellung des Aktors als Führungsmittel wirken.

In einer Ausgestaltung der Erfindung sind mehrere parallel zueinander angeordnete, flächige Aktorelemente vorgesehen. Vorteilhaft kann eine Kraft mehrerer Aktorelemente genutzt werden. Außerdem kann durch eine symmetrische Anordnung der Aktorelemente verhindert werden, dass bei einer Bewegung des Aktors aus der Grund- in die Arbeitsstellung Querkräfte auftreten. Die einzig auftretenden Kräfte sind vorzugsweise solche in einer Auslenkrichtung des Aktorelements und/oder einer Wirkrichtung der Kräfte der Rückstellmittel.

Zweckmäßigerweise ist mindestens ein zylinderförmiges Aktorelement vorgesehen, das aus einer zusammengerollten Aktorfolie gebildet ist. Vorteilhaft kann eine besonders kompakte Bauweise des Aktors erreicht werden. Eine Längenänderung erfolgt entlang der Zylinderachse und/oder in radialer Richtung. Eine Aktorfolie kann beispielsweise eine aus einem dielektrischen Elastomer gebildete Folie sein.

In einer weiteren Ausgestaltung der Erfindung ist zumindest eines der beiden Rückstellmittel vorgespannt und bildet ein Bauteil einer zu betätigenden Baugruppe, beispielsweise eines Ventils oder einer Bremse, oder ein Betätigungsmittel bildet ein Bauteil einer zu betätigenden Baugruppe, beispielsweise eines Ventils oder einer Bremse. Vorteilhaft wird eine Herstellung einer zu betätigenden Baugruppe vereinfacht. Eine separate Montage ist nicht erforderlich.

In einer Ausgestaltung der Erfindung weist das Aktorelement eine dielektrische Folie auf oder ist aus einer Formgedächtnislegierung gebildet. Bekannte Formgedächtnislegierungen umfassen beispielsweise Nickel und Titan.

Ein eine dielektrische Folie aufweisende Aktorelement ermöglicht einen besonders großen Hub, während ein aus einer Formgedächtnislegierung gebildetes Aktorelement zur Erzeugung einer großen Kraft besonders geeignet ist.

Die Erfindung wird nachfolgend anhand von Ausführungsbeispielen und der beigefügten, sich auf die Ausführungsbeispiele beziehenden Zeichnungen, näher erläutert. Es zeigen:
- Fig. 1: eine erste Ausführungsform der Erfindung in mehreren Ansichten,
- Fig. 2: eine zweite Ausführungsform der Erfindung in mehreren Ansichten,
- Fig. 3: eine besonders kompakte Ausführungsform der Erfindung in mehreren Ansichten.

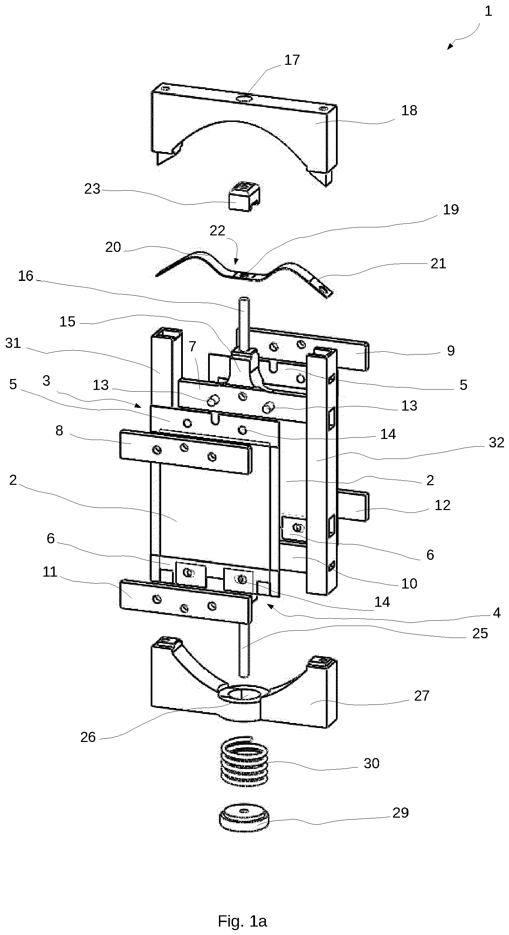

Ein in Fig. 1a in einer Explosionsdarstellung gezeigter Aktor (1) umfasst zwei folienförmige, aus einem dielektrischen Elastomermaterial gebildete Aktorelemente (2), die an zwei gegenüberliegenden Seiten (3,4) mit jeweils einem Halteabschnitt (5, 6) versehen und parallel zueinander angeordnet sind. Die ersten Halteabschnitte (5) werden zwischen einem ersten Klemmblock (7) und äußeren ersten Klemmschienen (8, 9) angebracht. Die unteren Halteabschnitte (6) werden zwischen einem zweiten Klemmblock (10) und äußeren weiteren Klemmschienen (11, 12) angebracht. Von jedem Klemmblock (7, 10) stehen in Richtung der Klemmschienen (8, 9, 11, 12) Haltestifte (13) vor, die zur Ausbildung einer Steckverbindung mit den Klemmschienen (8, 9, 11, 12) vorgesehen sind und durch Öffnungen (14) in dem Halteabschnitten (5, 6) hindurchgeführt sind. Eine besonders gute Fixierung kann vorteilhaft bewirkt werden.

Dadurch, dass die beiden Aktorelemente (2) in gleichem horizontalem Abstand von einer Längsachse von zylindrischen Führungsstiften (16, 25) angeordnet sind, treten bei einer Bewegung des Aktors (1) aus einer Grund- in eine Arbeitsstellung oder in eine Endstellung besonders vorteilhaft keine Querkräfte auf.

Obwohl in diesem Ausführungsbeispiel zwei Aktorelemente (2) vorgesehen sind, ist denkbar, dass ein einziges oder mehr als zwei Aktorelemente vorgesehen sind. Beispielsweise können drei Aktorelemente vorgesehen sein, von denen zwei in horizontalem Abstand von einer Längsachse der Führungsstifte (16, 25) angeordnet sind. Ein drittes Aktorelement kann derart angeordnet sein, dass dessen Auslenkungsrichtung bei der Bewegung in die Arbeitsstellung koaxial zur Längsachse der Führungsstifte (16, 25) ist.

An eine den Aktorelementen (2) abgewandte Seite des ersten Klemmblocks (7) ist ein Sockel (15) angeformt, von dem der erste Führungsstift (16) vorsteht, der in einen Führungskanal (17) eines ersten Aktorrahmenendteils (18) eingreift. Ferner ist der Stift (16) durch eine Öffnung (19) einer symmetrischen Schnappfeder (20) mit im eingebauten Zustand gebogenen Endabschnitten (21) hindurchgeführt. Zur Fixierung eines Mittelteils (22) der Schnappfeder (20) ist ein Fixierelement (23) vorgesehen, das mit einer der Schnappfeder (20) zugewandten Seite zur Ausbildung einer Rastverbindung mit einer der Schnappfeder (20) zugewandten Seite des Klemmblocks (7) eingerichtet ist.

An eine den Aktorelementen (2) abgewandte Seite des zweiten Klemmblocks (10) ist ein Sockel (24) angeformt, von dem der zweite Führungsstift (25) vorsteht, der durch einen Führungskanal (26) eines zweiten Aktorrahmenendteils (27) heraus aus einem die Aktorelemente (2) umgebenden Aktorrahmen (28) hindurchgeführt ist. Zwischen einer Außenseite des Aktorrahmenteils (27) und einem scheibenförmigen Abschlussstück (29) umgibt eine vorgespannte Schraubenfeder (30) den Führungsstift (25), der ein dem zweiten Klemmblock (10) abgewandtes Ende aufweist, das zur Verbindung mit dem Abschlussstück (29) vorgesehen ist.

Der Aktorrahmen (28) weist außerdem zwei Aktorrahmenseitenteile (31, 32) auf, die das erste und das zweite Aktorrahmenendteil (18, 27) miteinander verbinden. Die Endabschnitte (21) der Schnappfeder (20) werden zwischen den Aktorrahmenseitenteilen (31, 32) und dem Aktorrahmenendteil (18) mit dem Aktorrahmen (28) verbunden und sind in diesem Ausführungsbeispiel schräg zu jedem der Aktorrahmenseitenteile (31, 32) angeordnet.

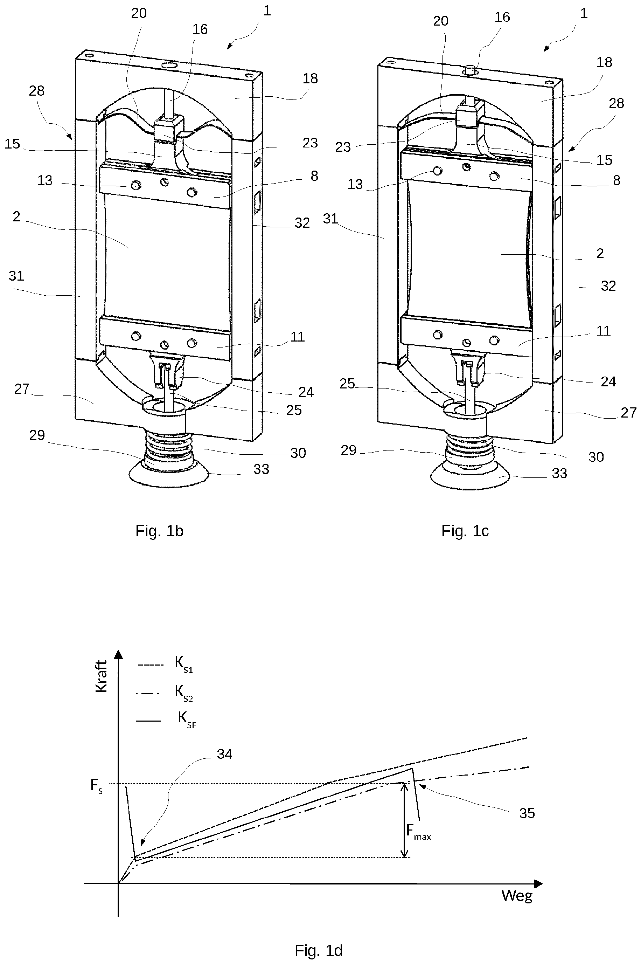

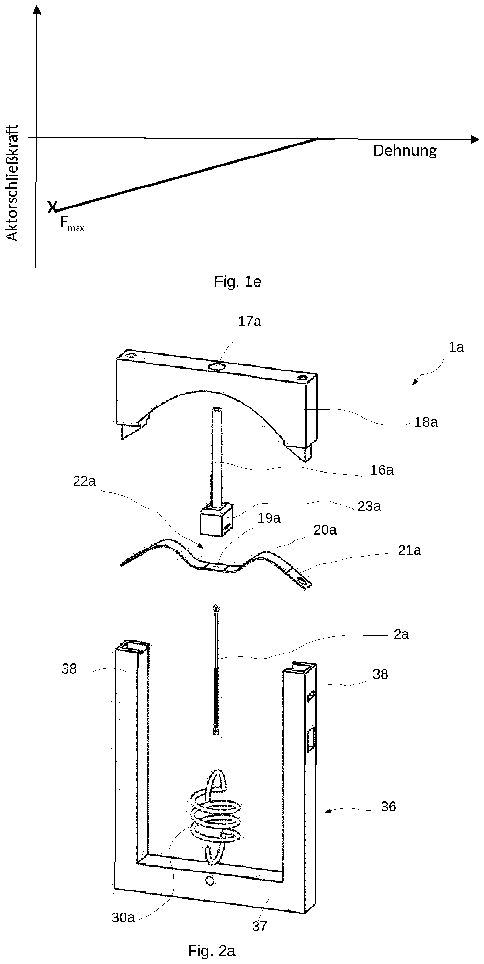

Eine elektrische Kontaktierung der Folienelemente sowie deren Ansteuerung erfolgt mit dem Fachmann bekannten Mitteln und ist in Fig. 1 nicht gezeigt.

Der Aktor (1) ist in Fig. 1b in einer Grundstellung gezeigt, in der keine Spannung an den Aktorelementen (2) anliegt und in Fig. 1c in einer Endstellung, in der das Abschlussstück (29) von einer in Fig. 1b und c gezeigten Grundplatte (33) abgehoben ist und die Aktorelemente (2) ausgelenkt sind.

Ferner ist die Schnappfeder (20) aus einer ersten Gleichgewichtsstellung in der Grundstellung des Aktors (19) in eine zweite Gleichgewichtsstellung in der Endstellung gewechselt. Jede Aktorstellung zwischen einer beispielsweise in Fig. 1b gezeigten Grundstellung und einer in Fig. 1c gezeigten Endstellung ist eine Arbeitsstellung. Jede Arbeitsstellung kann durch eine geeignete Wahl eines elektrischen Signals angesteuert werden. Bei einer Bewegung des Aktors (1) aus der Grund- in die Endstellung oder in eine Arbeitsstellung werden aufgrund der schwimmenden Lagerung die in Fig. 1b und c sichtbaren Klemmschienen (8, 11) aus einer in Fig. 1b gezeigten Stellung in eine in Fig. 1c gezeigte Stellung, die von derjenigen in Fig. 1b gezeigten verschieden ist, bewegt. Ein festes Widerlager ist nicht vorgesehen.

Wird der erfindungsgemäße Aktor (1) beispielsweise zur Ansteuerung eines Ventils verwendet, kann in der Grundstellung des Aktors (1) das Ventil geschlossen und in der Arbeitsstellung geöffnet sein. Eine maximal mögliche Offenstellung ist in Fig. 1c vereinfacht durch das Abheben des Abschlussstücks (29) von der Grundplatte (33) gezeigt.

Denkbar ist außerdem, dass der Aktor (1) zur Ansteuerung einer Bremse genutzt wird. Eine Bremsstellung entspricht dabei der Grundstellung des Aktors und eine maximale Freigabestellung der Endstellung des Aktors. Dazu kann das Abschlussstück (29) beispielsweise als Bremsbelag ausgebildet sein, der in der Bremsstellung gegen eine als Bremsscheibe ausgebildete Grundplatte (33) drückt.

In einem in Fig. 1d schematisch gezeigten Kraft-Weg-Diagramm ist eine konstante Kraft F_{S} gezeigt, die der Vorspannkraft der Feder (30) entspricht und die beispielsweise zum Öffnen eines Ventils oder zum Öffnen einer Bremse überwunden werden muss.

Ferner sind die beiden Kennlinien der Schnappfeder (20) K_{SF} gezeigt, sowie diejenigen Kennlinien K_{S1} und K_{S2} eines Systems aus den Aktorelementen (2) sowie der Feder (30), wobei K_{S1} die Kennlinie bei einer an das Aktorelement angelegten Spannung von 0 V und K_{S2} die Kennlinie bei einer das Aktorelement angelegten Spannung von größer 0V, beispielsweise 2000 V. Sowohl die Grundstellung des Aktors als auch die Endstellung des Aktors sind Gleichgewichtslagen des Systems. Die Grundstellung ist eine erste Gleichgewichtslage (34), die in Fig. 1d ein Schnittpunkt der Kennlinie K_{SF} mit K_{S1} ist, während eine zweite Gleichgewichtslage (35) ein Schnittpunkt der Kennlinie K_{SF} mit K_{S2} ist.

Eine Schnappfeder ist durch die Kennlinie K_{SF} charakterisiert.

Dadurch, dass die Aktorelemente (2) zwischen der Feder (30) und der Schnappfeder (20) gelagert sind, kann der Aktor eine hohe Kraft Fₘₐₓ leisten, die beispielsweise zum Öffnen eines Ventils oder zum Andrücken eines Bremsbelags gegen eine Bremsscheibe genutzt werden kann.

Ein Verlauf der Aktorkraft als Funktion der Dehnung der Aktorelemente (2) ist schematisch in Fig. 1e gezeigt.

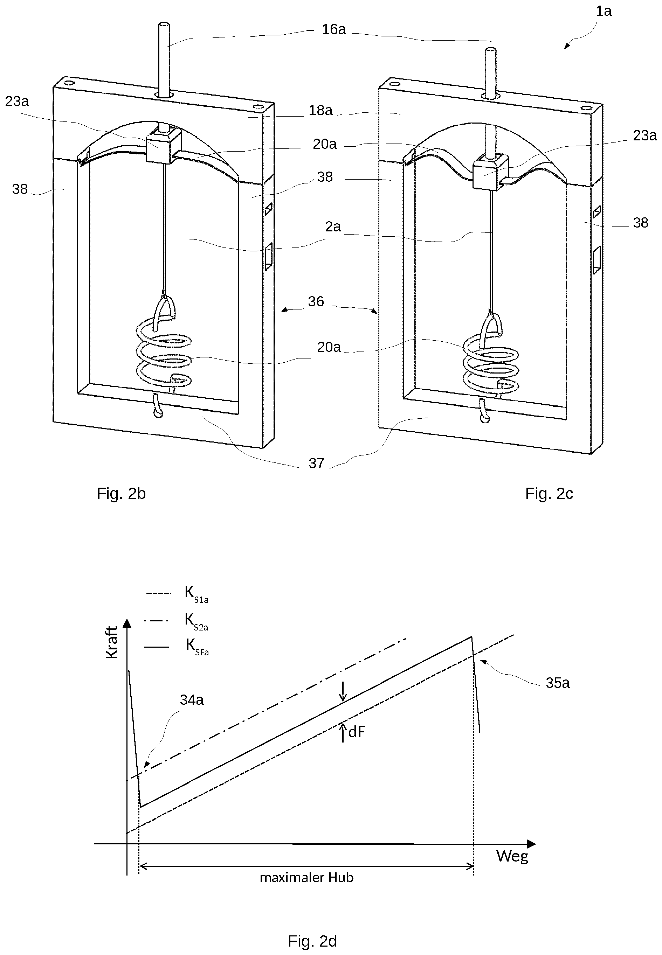

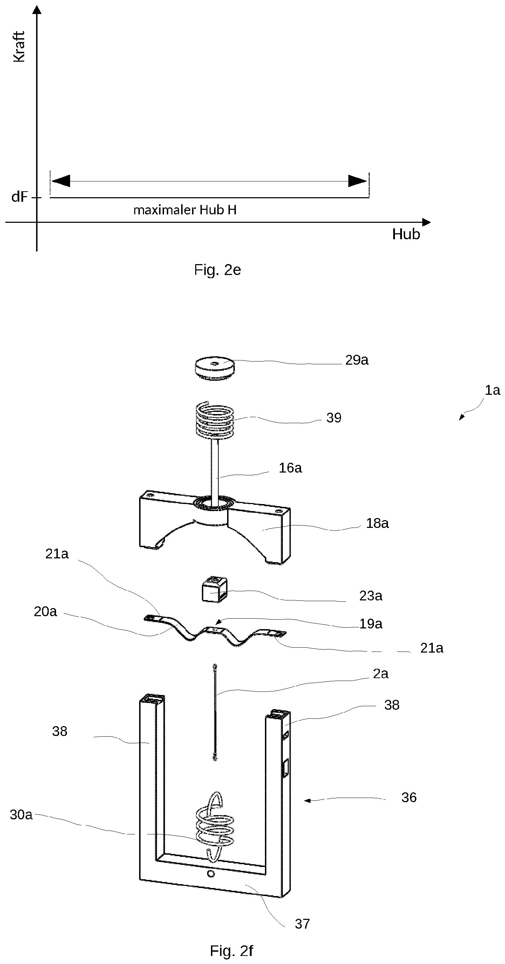

Es wird nun auf Fig. 2 Bezug genommen, wo gleiche oder gleichwirkende Teile mit derselben Bezugszahl wie in Fig. 1 bezeichnet sind und der betreffenden Bezugszahl jeweils der Buchstabe a beigefügt ist.

Ein in Fig. 2a gezeigter Aktor (1a) unterscheidet sich von demjenigen in Fig. 1a gezeigten dadurch, dass ein Aktorelement (2a) aus einer Formgedächtnislegierung (SMA, shape memory alloy), insbesondere aus einer Nickel und Titan aufweisenden Formgedächtnislegierung gebildet und drahtförmig ist. Ferner weist ein Aktorrahmen des Aktorelements ein U-förmiges Aktorrahmenunterteil (36) auf, dessen Basisschenkel (37) zur Verbindung mit einer Feder (30a) eingerichtet ist.

In einer in Fig. 2b gezeigten Grundstellung des Aktors (1a) ist das Aktorelement (2a) in einem gelängten, verformten Zustand. In einer in Fig. 2c gezeigten Endstellung ist das Aktorelement (2a) in einem ursprünglichen Grundzustand, in dem es kürzer ist als in der Grundstellung des Aktors (1a). Ein Wechsel aus dem gelängten in den Grundzustand kann beispielsweise durch eine Erwärmung bewirkt werden, die durch eine Beaufschlagung mit einem Strom I möglich ist.

In einem in Fig. 2d schematisch gezeigten Kraft-Weg-Diagramm ist ein maximal möglicher Hub H gezeigt. Ferner sind die beiden Kennlinien der Schnappfeder (20a) K_{SFa} gezeigt, sowie diejenigen Kennlinien K_{S1a} und K_{S2a} eines Systems aus den Aktorelement (2a) sowie der Feder (30a), wobei K_{S2a} die Kennlinie in einem gelängten Zustand des Aktorelements und K_{S1a} die Kennlinie bei Erwärmumg des Aktorelements ist. Sowohl eine Grundstellung des Aktors als auch eine Endstellung sind Gleichgewichtslagen des Systems. Die Grundstellung ist eine erste Gleichgewichtslage (34a), die in Fig. 2d ein Schnittpunkt der Kennlinie K_{SFa} mit K_{S2a} ist, während eine zweite Gleichgewichtslage (35a) ein Schnittpunkt der Kennlinie K_{SFa} mit K_{S1a} ist.

Dadurch, dass das Aktorelement (2a) zwischen der Feder (30a) und der Schnappfeder (20a) gelagert ist, kann eine geringe Längenänderung des Aktorelements (2a) einen hohen Hub H bewirken. Dies ist in Fig. 2e schematisch gezeigt. Eine in Fig. 2d gezeigte Kraft dF bezeichnet eine maximale Kraft, die mit dem erfindungsgemäßen Aktor erzeugt werden kann.

Bei einer in Fig. 2f gezeigten besonderen Ausführungsform eines Aktors (1a) sind Endabschnitte (21a) einer Schnappfeder (20a) senkrecht zu Schenkeln (38) eines Aktorrahmenunterteils (36) angeordnet. Ferner umfasst der Aktor (1a) eine weitere, vorgespannte Schraubenfeder (39), die ein Führungsmittel (16a) umgibt und gegen ein Abschlussstück (29a) anliegt. Durch diese Anordnung aus drei Rückstellmitteln (20, 30a, 39) ist eine Gesamtrückstellmittelkennlinie des Aktors (1a) derart einstellbar, dass ein Zurückschnappen der Schnappfeder (20a) aus der Arbeitsstellung in die Grundstellung und über die Grundstellung hinaus vorteilhaft verhindert wird.

Außerdem ist die Gesamtrückstellmittelkennlinie mit derjenigen des in Fig. 2a bis c gezeigten Aktors vergleichbar.

Ohne die weitere Feder (39) wäre eine Gesamtrückstellmittelkennline derart verändert, dass die Schnappfeder (20a) sowohl in Richtung einer Feder (30a) als auch von einer Feder (30a) weg schnappen könnte.

Während ein in Fig. 1 gezeigter Aktor (1) zur Erzeugung einer großen Kraft, die an einer einer Grundplatte (33) zugewandten Seite nutzbar ist, besonders geeignet ist, ist ein in Fig. 2 gezeigter Aktor (1a) zur Erzeugung eines besonders großen Hubes geeignet.

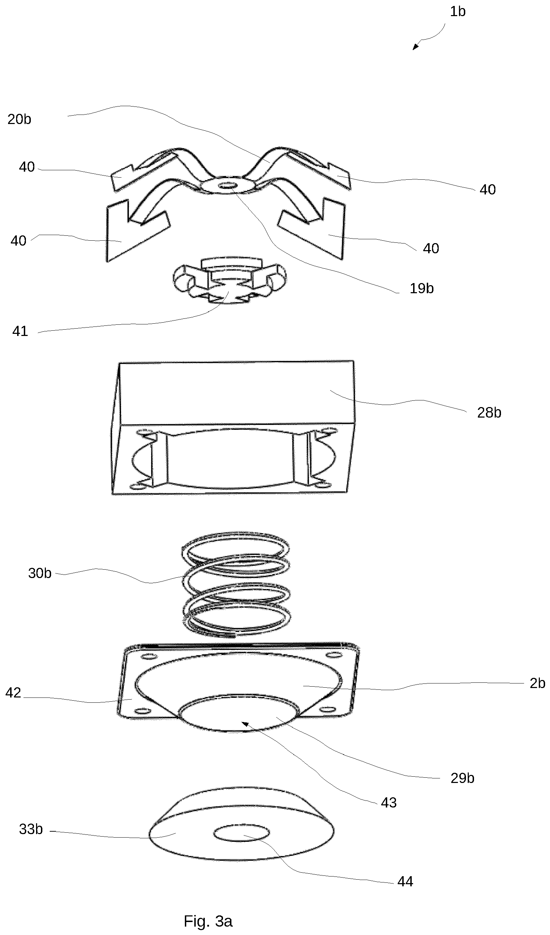

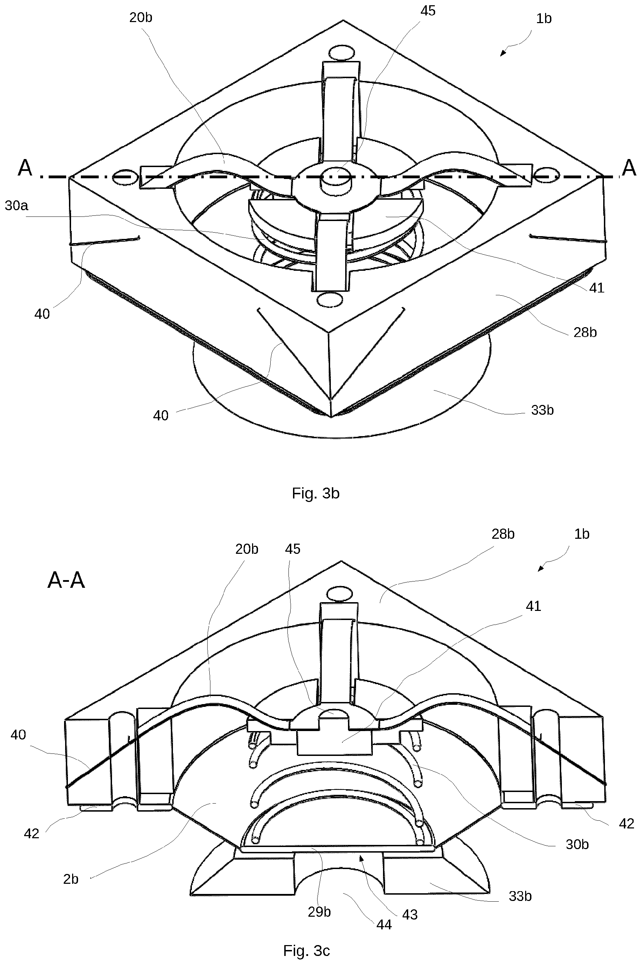

Es wird nun auf Fig. 3 Bezug genommen, wo gleiche oder gleichwirkende Teile mit derselben Bezugszahl wie in Fig. 1 und 2 bezeichnet sind und der betreffenden Bezugszahl jeweils der Buchstabe b beigefügt ist.

Eine in Fig. 3 in einer Explosionsdarstellung gezeigte besondere Ausführungsform eines Aktors (1b) unterscheidet sich von derjenigen in Fig. 1 gezeigten dadurch, dass ein rotationssymmetrisches, membranförmiges, dielektrisches Aktorelement (2b) aus einer Membranebene heraus auslenkbar ist.

Eine Schnappfeder (20b) weist vier Federarme mit widerhakenförmigen Enden (40) auf, mit denen die Schnappfeder (20b) mit einem Aktorrahmen (28b) kraft-, form- und/oder stoffschlüssig verbunden werden kann. Während in diesem Ausführungsbeispiel der Akotorrahmen (28b) bei einer Bewegung des Aktors (1b) aus einer Grundstellung heraus in eine Arbeitsstellung bewegbar ist, ist ein Halteelement (41), das die Schnappfeder (20b) mit einer Schraubenfeder (30b) verbindet und als Widerlager für die beiden Federn (20b, 30b) vorgesehen ist, ortsfest angeordnet und kann beispielsweise an einem in Fig. 3 nicht gezeigten Halterahmen befestigt sein. Dazu kann ein von einer der Schraubenfeder (30b) abgewandten Seite des Halteelementes (41) vorstehender Zapfen (45), der durch eine Öffnung (19b) in der Schnappfeder (20b) hindurchtritt, mit einem Außengewinde versehen sein, in das ein Halterohr des Halterahmens mit einem Innengewinde eingeschraubt wird.

Das Aktorelement (2b) ist ferner als dielektrische Elastomerfolie ausgebildet und in einen zweiteiligen, an dem Aktorrahmen (28b) befestigten Aktorelementhalterahmen (42) derart eingebracht, dass eine Auslenkung des Aktorelementes (2b) membranartig, das heißt durch eine Wölbung parallel oder vorzugsweise koaxial zu einer Auslenkungsrichtung der Schraubenfeder (30b) erfolgen kann. Ein Abschlussstück (29b) ist fest mit dem Aktorelement (2b) verbunden und bewirkt eine Abflachung von dessen Außenseite. Die Schraubenfeder (30b) ist zwischen dem ortsfesten Halteelement (41) und dem Abschlussstück (29b) angeordnet.Der bewegbare Aktorrahmen (28b) und das Aktorelement (2b) bilden einen Teil eines bewegbaren Aktorgehäuses.

Fig. 3b zeigt den in Fig. 3a dargestellten Aktor in einer perspektivischen Ansicht.

In einer Grundstellung des Aktors (1b), die in Fig. 3c im Schnitt A-A gezeigt ist, liegt eine einer Grundplatte (33b) zugewandte Seite (43) des Abschlussstücks (29b) gegen die Grundplatte (33b) an und überdeckt eine Öffnung (44). Bei einer Bewegung in eine Endstellung, das heißt in eine maximal möglichen Arbeitsstellung des Aktors (1b), werden das Abschlussstück (29b) und der bewegbare Aktorrahmen (28b) vertikal von der Grundplatte (33b) weg bewegt. Durch die vier mit dem bewegbaren Aktorrahmen (28b) verbundenen Federarme der Schnappfeder (20b), deren Längsachsen rechtwinklig zueinander angeordnet sind, ist eine geführte Linearbewegung möglich.

Eine Kraft-Weg-Kennlinie des in Fig. 3 gezeigten Aktors (1b) ist qualitativ identisch zu derjenigen in Fig. 1d gezeigten.

Die in Fig. 3 gezeigte Ausführungsform ermöglicht vorteilhaft eine kompakte Bauweise des Aktors.

Obwohl in den in Fig. 1, 2a bis 2e sowie Fig. 3 gezeigten Ausführungsbeispielen zwei Rückstellmittel (20, 30; 20a, 30a; 20b, 30b) vorgesehen sind, ist denkbar, dass ein Aktorelement (2, 2a; 2b) zwischen mehreren auf das Aktorelement einwirkenden Rückstellmitteln angeordnet ist, die ferner unterschiedlich ausgebildet sein können und voneinander verschiedene Rückstellmittelkennlinien aufweisen können.

## Patentansprüche

1. Aktor (1; 1a; 1b), der aus einer Grundstellung heraus in eine Arbeitsstellung bewegbar ist und mindestens ein in seinen Abmessungen durch ein elektrisches Signal veränderbares Aktorelement (2; 2a; 2b) aufweist, wobei zur Bewegung in die Arbeitsstellung mindestens zwei auf das Aktorelement (2; 2a; 2b) einwirkende Rückstellmittel (20, 30; 20a, 30a; 20b, 30b) vorgesehen sind und wobei das mindestens eine Aktorelement (2; 2a; 2b) zwischen den mindestens zwei auf das Aktorelement (2; 2a; 2b) einwirkenden Rückstellmitteln (20, 30; 20a, 30a; 20b, 30b, 39) schwimmend gelagert ist,
**dadurch gekennzeichnet,**
**dass** ein erstes Rückstellmittel mindestens eine nichtlineare Feder umfasst.

2. Aktor nach Anspruch 1,
**dadurch gekennzeichnet,**
**dass** das erste (20; 20a; 20b) und ein zweites (30; 30a; 30b) Rückstellmittel gleich oder voneinander verschieden sind.

3. Aktor nach einem der Ansprüche 1 oder 2,
**dadurch gekennzeichnet,**
**dass** das erste Rückstellmittel mindestens eine Schnappfeder (20; 20a; 20b), und/oder ein zweites Rückstellmittel mindestens eine lineare Feder, insbesondere eine Schraubenfeder (30; 30a; 30b), umfasst.

4. Aktor nach einem der Ansprüche 1 bis 3,
**dadurch gekennzeichnet,**
**dass** eines der Rückstellmittel (20; 20a, 20b) mindestens eine nichtlineare Feder aufweist, die vorzugsweise als Schnappfeder ausgebildet ist, deren Endabschnitte (21; 21a; 37) schräg, waagerecht oder senkrecht zu einem Aktorrahmenseitenteil (31, 31; 36) eines Aktorrahmens (28, 28b) angeordnet sind.

5. Aktor nach einem der Ansprüche 1 bis 4,
**dadurch gekennzeichnet,**
**dass** das mindestens eine Aktorelement planar (2), zylindrisch (2a) oder kegelstumpfförmig (2b) ausgebildet ist.

6. Aktor nach einem der Ansprüche 1 bis 5,
**dadurch gekennzeichnet,**
**dass** eine Länge des mindestens einen Aktorelements (2; 2a; 2b) durch ein elektrisches Signal veränderbar ist, wobei eine Längenänderung vorzugsweise in einer Aktorelementebene oder entlang einer Symmetrieachse in einer Längsrichtung erfolgt.

7. Aktor nach einem der Ansprüche 1 bis 6,
**dadurch gekennzeichnet,**
**dass** das mindestens eine Aktorelement (2; 2a; 2b) in eine Richtung auslenkbar ist, die parallel oder koaxial zu einer Wirkrichtung einer Rückstellkraft mindestens eines der auf das Aktorelement (2; 2a; 2b) einwirkenden Rückstellmittel (20, 30; 20a, 30a; 20b, 30b, 36) ist.

8. Aktor nach einem der Ansprüche 1 bis 7,
**dadurch gekennzeichnet,**
**dass** wenigstens eines der beiden Rückstellmittel (20, 30; 20a; 30a; 20b, 30b) innerhalb eines Aktorrahmens (28; 28b) oder Aktorgehäuses angeordnet ist.

9. Aktor nach einem der Ansprüche 1 bis 8,
**dadurch gekennzeichnet,**
**dass** ein erster Endabschnitt (3) des mindestens einen Aktorelements und ein zweiter, dem ersten Abschnitt vorzugsweise gegenüberliegender Endabschnitt (4) mit Halteelementen, insbesondere Klemmschienen (8, 9, 10, 11), versehen sind.

10. Aktor nach einem der Ansprüche 1 bis 9,
**dadurch gekennzeichnet,**
**dass** ein Betätigungsmittel (16, 25; 16a; 16b) vorgesehen ist, das gleichzeitig zur Führung einer Bewegung aus der Grundstellung heraus in die Arbeitsstellung eingerichtet ist.

11. Aktor nach einem der Ansprüche 1 bis 10,
**dadurch gekennzeichnet,**
**dass** mehrere parallel zueinander angeordnete, flächige Aktorelemente (2) vorgesehen sind.

12. Aktor nach einem der Ansprüche 1 bis 10,
**dadurch gekennzeichnet,**
**dass** mindestens ein zylinderförmiges Aktorelement (2a) vorgesehen ist, das aus einer zusammengerollten Aktorfolie gebildet ist.

13. Aktor nach einem der Ansprüche 1 bis 12,
**dadurch gekennzeichnet,**
**dass** zumindest eines der beiden Rückstellmittel (20, 30; 20a; 30a) vorgespannt ist und ein Bauteil einer zu betätigenden Baugruppe, beispielsweise eines Ventils oder einer Bremse, bildet, oder dass ein Betätigungsmittel (16a) ein Bauteil einer zu betätigenden Baugruppe, beispielsweise eines Ventils oder einer Bremse, bildet.

14. Aktor nach einem der Ansprüche 1 bis 13,
**dadurch gekennzeichnet,**
**dass** das Aktorelement (2; 2a; 2b) eine dielektrische Folie aufweist oder aus einer Formgedächtnislegierung gebildet ist.

## Claims

1. Actuator (1; 1a; 1b) which can be moved from an initial position into a working position and has at least one actuator element (2; 2a; 2b) whose dimensions can be changed by an electrical signal, wherein at least two restoring means (20, 30; 30a, 20b; 30b) acting on the actuator element (2; 2a; 2b) are provided for movement into the working position and wherein the at least one actuator element (2; 2a; 2b) is floatingly mounted between the at least two restoring means (20, 30; 20a, 30a; 20b, 30b, 39) acting on the actuator element (2; 2a; 2b), **characterised in that** a first restoring means comprises at least one non-linear spring.

2. Actuator according to claim 1, **characterised in that** the first (20; 20a; 20b) and a second (30; 30a; 30b) restoring means are the same or different from each other.

3. Actuator according to one of claims 1 or 2, **characterised in that** the first return means comprises at least one snap spring (20; 20a; 20b), and/or a second return means comprises at least one linear spring, in particular a helical spring (30; 30a; 30b).

4. Actuator according to one of claims 1 to 3, **characterised in that** one of the restoring means (20; 20a, 20b) comprises at least one non-linear spring, which is preferably designed as a snap spring, the end sections (21; 21a; 37) of which are arranged obliquely, horizontally or perpendicularly to an actuator frame side part (31, 31; 36) of an actuator frame (28, 28b).

5. Actuator according to one of claims 1 to 4, **characterised in that** the at least one actuator element is planar (2), cylindrical (2a) or frustoconical (2b).

6. Actuator according to one of claims 1 to 5, **characterised in that** a length of the at least one actuator element (2; 2a; 2b) can be changed by an electrical signal, a change in length preferably taking place in an actuator element plane or along an axis of symmetry in a longitudinal direction.

7. Actuator according to one of claims 1 to 6, **characterised in that** the at least one actuator element (2; 2a; 2b) can be deflected in a direction which is parallel or coaxial to an effective direction of a restoring force of at least one of the restoring means (20, 30; 20a, 30a; 20b, 30b, 36) acting on the actuator element (2; 2a; 2b).

8. actuator according to one of claims 1 to 7, **characterised in that** at least one of the two restoring means (20, 30; 20a; 30a; 20b, 30b) is arranged within an actuator frame (28; 28b) or actuator housing.

9. Actuator according to one of claims 1 to 8, **characterised in that** a first end portion (3) of the at least one actuator element and a second end portion (4), preferably opposite the first portion, are provided with retaining elements, in particular clamping rails (8, 9, 10, 11).

10. Actuator according to one of claims 1 to 9, **characterised in that** an actuating means (16, 25; 16a; 16b) is provided which is simultaneously set up to guide a movement from the initial position into the working position.

11. Actuator according to one of claims 1 to 10, **characterised in that** a plurality of planar actuator elements (2) arranged parallel to one another are provided.

12. Actuator according to one of claims 1 to 10, **characterised in that** at least one cylindrical actuator element (2a) is provided, which is formed from a rolled-up actuator foil.

13. actuator according to one of claims 1 to 12, **characterised in that** at least one of the two restoring means (20, 30; 20a; 30a) is preloaded and forms a component of an assembly to be actuated, for example a valve or a brake, or **in that** an actuating means (16a) forms a component of an assembly to be actuated, for example a valve or a brake.

14. actuator according to one of claims 1 to 13, **characterised in that** the actuator element (2; 2a; 2b) comprises a dielectric foil or is formed of a shape memory alloy.

## Revendications

1. Actionneur (1 ; 1a ; 1b) qui peut être déplacé d'une position de départ à une position de travail et qui présente au moins un élément d'actionnement (2 ; 2a ; 2b) dont les dimensions peuvent être modifiées par un signal électrique, au moins deux moyens de rappel (20, 30 ; 20a, 30a ; 20b, 30b) sont prévus pour le mouvement dans la position de travail et où l'au moins un élément d'actionnement (2 ;2a ; 2b) est logé de manière flottante entre les au moins deux moyens de rappel (20, 30 ; 20a, 30a ; 20b, 30b, 39) agissant sur l'élément d'actionnement (2 ; 2a ; 2b), **caractérisé en ce qu'**un premier moyen de rappel comprend au moins un ressort non linéaire.

2. Actionneur selon la revendication 1, **caractérisé en ce que** le premier (20 ; 20a ; 20b) et un deuxième (30 ; 30a ; 30b) moyen de rappel sont identiques ou différents l'un de l'autre.

3. Actionneur selon l'une des revendications 1 ou 2, **caractérisé en ce que** le premier moyen de rappel comprend au moins un ressort à déclic (20 ; 20a ; 20b), et/ou un deuxième moyen de rappel comprend au moins un ressort linéaire, notamment un ressort hélicoïdal (30 ; 30a ; 30b).

4. Actionneur selon l'une des revendications 1 à 3, **caractérisé en ce que** l'un des moyens de rappel (20 ; 20a, 20b) comporte au moins un ressort non linéaire, de préférence un ressort à déclic, dont les portions d'extrémité (21 ; 21a ; 37) sont disposées obliquement, horizontalement ou perpendiculairement à une partie latérale (31, 31 ; 36) d'un cadre d'actionneur (28, 28b).

5. Actionneur selon l'une des revendications 1 à 4, **caractérisé en ce que** ledit au moins un élément actionneur est plan (2), cylindrique (2a) ou tronconique (2b).

6. Actionneur selon l'une des revendications 1 à 5, **caractérisé en ce qu'**une longueur de l'au moins un élément d'actionneur (2 ; 2a ; 2b) peut être modifiée par un signal électrique, une modification de longueur s'effectuant de préférence dans un plan de l'élément d'actionneur ou le long d'un axe de symétrie dans une direction longitudinale.

7. Actionneur selon l'une des revendications 1 à 6, **caractérisé en ce que** l'au moins un élément d'actionneur (2 ; 2a ; 2b) peut être dévié dans une direction qui est parallèle ou coaxiale à une direction d'action d'une force de rappel d'au moins un des moyens de rappel (20, 30 ; 20a, 30a ; 20b, 30b, 36) agissant sur l'élément d'actionneur (2 ; 2a ; 2b).

8. Actionneur selon l'une des revendications 1 à 7, **caractérisé en ce qu'**au moins l'un des deux moyens de rappel (20, 30 ; 20a ; 30a ; 20b, 30b) est disposé à l'intérieur d'un cadre d'actionneur (28 ; 28b) ou d'un boîtier d'actionneur.

9. Actionneur selon l'une des revendications 1 à 8, **caractérisé en ce qu'**une première section d'extrémité (3) de l'au moins un élément d'actionneur et une deuxième section d'extrémité (4), de préférence opposée à la première section, sont pourvues d'éléments de retenue, en particulier de rails de serrage (8, 9, 10, 11).

10. Actionneur selon l'une des revendications 1 à 9, **caractérisé en ce qu'**il est prévu un moyen d'actionnement (16, 25 ; 16a ; 16b) qui est simultanément agencé pour guider un mouvement de la position initiale vers la position de travail.

11. Actionneur selon l'une des revendications 1 à 10, **caractérisé en ce qu'**il est prévu plusieurs éléments d'actionneur (2) plats, disposés parallèlement les uns aux autres.

12. Actionneur selon l'une des revendications 1 à 10, **caractérisé en ce qu'**il est prévu au moins un élément d'actionneur (2a) de forme cylindrique, qui est formé d'une feuille d'actionneur enroulée.

13. Actionneur selon l'une des revendications 1 à 12, **caractérisé en ce qu'**au moins l'un des deux moyens de rappel (20, 30 ; 20a ; 30a) est précontraint et forme un composant d'un ensemble à actionner, par exemple une vanne ou un frein, ou **en ce qu'**un moyen d'actionnement (16a) forme un composant d'un ensemble à actionner, par exemple une vanne ou un frein.

14. Actionneur selon l'une quelconque des revendications 1 à 13, **caractérisé en ce que** l'élément d'actionneur (2 ; 2a ; 2b) comprend une feuille diélectrique ou est formé d'un alliage à mémoire de forme.
